# EUROPÄISCHE PATENTANMELDUNG

(11) **EP 0 654 836 A1**
(43) Veröffentlichungstag der Anmeldung: **24.05.1995**
(21) Anmeldenummer: 94250263.4
(22) Anmeldetag: 25.10.1994
(51) Int. Cl.: H01L 51/00

(54) **Bioelektrische Anordnung**

(30) Priorität: 19.11.1993 DE 4339927
(71) Anmelder: INSTITUT FÜR BIOPROZESS- UND ANALYSENMESSTECHNIK e.V., D-37308 Heiligenstadt (DE)
(72) Erfinder: Beckmann, Dieter, Dipl.-Phys., D-37308 Heiligenstadt (DE); Gruber, Ronald, Dipl.-Biochem., D-37308 Geisleden (DE); Müller, Adrian, Dipl.-Ing., D-37308 Heiligenstadt (DE); Klingebiel, Ursula, D-37308 Heiligenstadt (DE)
(74) Vertreter: Maikowski, Michael, Dipl.-Ing. Dr.

(57) **Zusammenfassung**

Die Erfindung betrifft eine bioelektrische Anordnung unter Verwendung eines strahlungsempfindlichen biologischen Materials, das in einem lyotropen Flüssigkristall eingebettet ist. Erfindungsgemäß ist vorgesehen, daß die Anordnung mindestens aus einem Tensid, aus Bakteriorhodopsin oder Bakteriorhodopsin enthaltenden Membranstücken und Wasser besteht.

## Beschreibung

Die Erfindung betrifft eine Bioelektrische Anordnung nach dem Oberbegriff des Anspruchs 1.

Eine bioelektrische Anordnung nach der DE-OS 42 24 603 verwendet strahlungsempfindliches biologisches Material, das in einem lyotropen Flüssigkristall eingebettet ist. Zum Abgriff des elektrischen Signals sind Elektroden direkt am Flüssigkristall angebracht.

Eine weiterentwickelte bioelektrische Anordnung weist die Merkmale des kennzeichnenden Teils des Anspruchs 1 auf.

Die erfindungsgemäße Anordnung besteht mindestens aus einem Tensid, aus Bakteriorhodopsin oder Bakteriorhodopsin enthaltenden Membranstücken und Wasser. Als Tenside können z.B. Polyoxyethylenmonolaurylether, n-Polyoxyethylen-m-alkylether, N-Laurylsarkosin (NLS) oder Cetylpyridiniumchlorid (CPC) verwendet werden. Bei Verwendung von NLS und CPC ist zusätzlich ein mit Wasser nicht mischbares Lösungsmittel, z.B. Hexan oder Benzol zugefügt.

Der lyotrope Flüssigkristall kann als Schicht zwischen zwei Glasplatten eingebracht sein und die Elektroden sind in diese Schicht eingefügt.

In einer weiteren Ausführungsform befindet sich der Flüssigkristall in einem lichtdurchlässigen Rohr, das an den Stirnseiten, z.B. durch Schieber, verschlossen ist. In diesem Fall erstrecken sich die Elektroden durch die Stirnseiten in den Flüssigkristall.

Als Elektroden sind zweckmäßig Edelmetallelektroden vorgesehen.

Der lyotrope Flüssigkristall kann auch zwischen zwei elektrisch leitende Gläsern oder zwei mit Edelmetallen bedampften Gläsern eingebracht sein. Die Gläser werden dann auch als Elektroden verwendet.

Die beschriebene Bioelektrische Anordnung kann zur Detektion von sichtbarem Licht, UV-Licht und Gammastrahlen verwendet werden.

Die Erfindung soll in Ausführungsbeispielen erläutert werden.

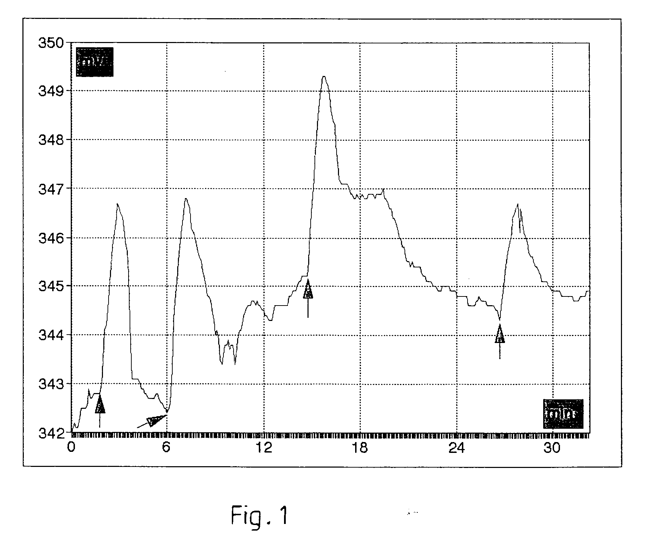

Die Figuren 1 bis 3 zeigen Versuchsergebnisse, die mit einer Probe bei unterschiedlicher Bestrahlung erzielt wurden.

Der Flüssigkristall mit dem eingebetteten strahlungsempfindlichen biologischen Material besteht aus 1 g des Tensids Polyoxyethylenmonolaurylether (Handelsname Brij 35) und 1ml einer wäßrigen Suspension von Bakteriorhodopsin, die unter erhöhter Temperatur in Lösung gebracht werden, wobei sich bei der anschließenden Abkühung der lyotrope Flüssigkristall ausbildet. Das Bakteriorhodopsin lagert sich innerhalb dessen dreidimensionaler Struktur ähnlich gerichtet wie in den nativen Zellmembranen ein. Makroskopisch betrachtet hat der so gebildete lyotrope Flüssigkristall eine gelartige, hochviskose und optisch transparente Konsistenz.

Der lyotrope Flüssigkristall bildet sich in gleicher Weise aus anderen Tensid-Wassergemischen. Dabei können verschiedene Mischungsverhältnisse zwischen Tensid und Wasser bestehen. Zur Bildung eines stabilen lyotropen Flüssigkristalls bei Verwendung NLS und CPC als Tensid wird wie folgt verfahren:
Es wird eine Suspension, bestehend aus dem Tensid und dem organischen Lösungsmittel hergestellt. Anschlließend wird dieser Suspension Wasser zugegeben, das Bakteriorhodopsin oder Bakteriorhodopsin enthaltende Membranstücke enthält. nach kurzem Schütteln bildet sich ein zweiphasiges System, bestehend aus dem lyotropen Flüssigkristall und reinem Lösungsmittel. Die Mischungsverhältnisse ergeben sich aus dem entsprechenden ternären Zustandsdiagramm.

Dieser Flüssigkristall ist als Schicht mit einer Dicke von 0,2 bis 0,5 mm zwischen zwei Glasplatten angeordnet. Im Abstand von einem Zentimeter sind zwei Platindrähte als Elektroden in diese Schicht eingelegt.

In einer anderen Ausführungsform ist der lyotrope Flüssigkristall in einem lichtdurchlässigen Röhrchen vorgesehen, das mit Schiebern verschlossen ist. Dabei ist ein aus Polyoxyethylenmonolaurylether als Tensid und 1 %iger wäßriger Kaliumchloridlösung als Wasserphase bestehender und Bakteriorhodopsin enthaltender lyotroper Flüssigkristall in einem Plastikröhrchen (Durchmesser 0,5 cm, Länge 2 cm) vorgesehen, der an beiden Enden mit Platindrähten kontaktiert ist. Diese Anordnung wird über einen Meßverstärker an einen Datenlogger angeschlossen und die Ergebnisse werden über einen Personalcomputer ausgewertet.

In der Figur 1 sind die mit dieser bioelektrischen Anordnung erzielten Meßergebnisse bei Bestrahlung mit sichtbarem Licht dargestellt. Die Proben wurden mit einer Wolframlampe von 25 Watt/%Volt im Abstand von 17 cm bestrahlt. Die Probe wurde ab den in der Fig.1 mit Pfeilen markierten Zeitpunkten für eine Minute belichtet. Dadurch werden die dargestellten Spannungsdifferenzen erzielt, die ca. 3 mV betragen. Nach Beendigung der Belichtung geht die Spannung wieder in den Ausgangszustand zurück.

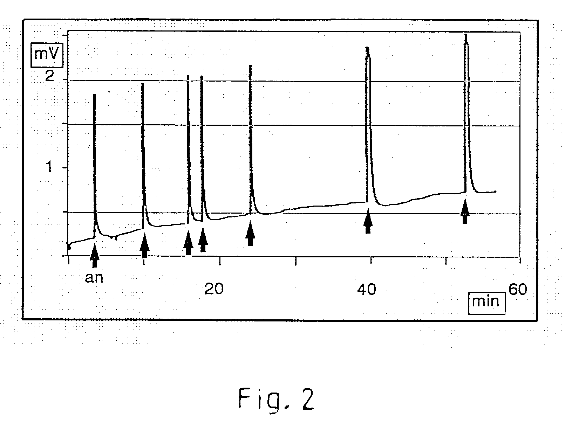

In der Figur 2 sind die Meßergebnisse bei Bestrahlung dieser bioelektrischen Anordnung mit UV-Licht dargestellt. Die Proben wurden mit einer UV-Lampe im Abstand von 10 cm bestrahlt. Ab den mit Pfeilen markierten Zeitpunkten wird die Probe für eine Minute bestrahlt. Die dadurch erzielte Spannungsdifferenz beträgt 2mV. Nach Beendigung der Belichtung geht die Spannung auch hier wieder in den Ausgangszustand zurück.

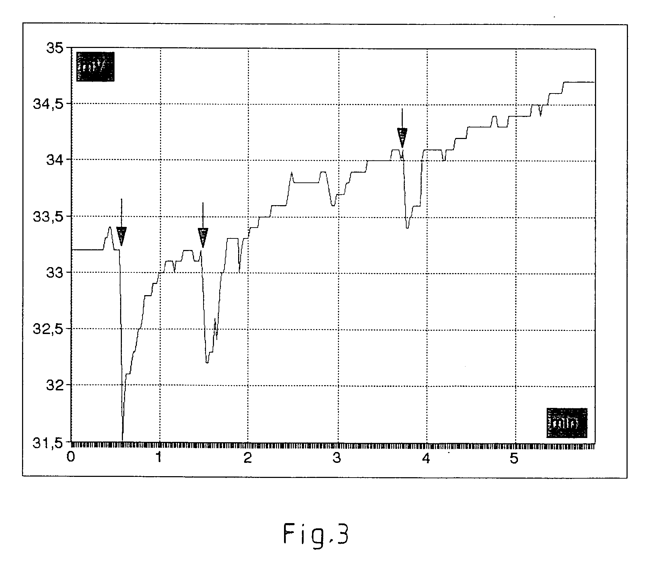

In der Fig. 3 sind Meßergebnisse dargestellt, die bei Bestrahlung der Probe mit Gamma-Strahlen erzielt wurden. Die Bestrahlung erfolgte mit Americium 241/ 65 keV im Abstand von 3 cm. Ab den mit Pfeilen markierten Zeitpunkten wurde die Probe für 15 Sekunden bestrahlt. Es wurde eine Spannungsdifferenz von 0,5 bis 1,5 mV erzielt. Auch in diesem Fall geht die Spannung nach Beendigung der Bestrahlung wieder in den Ausgangszustand zurück.

## Patentansprüche

1. Bioelektrische Anordnung unter Verwendung eines strahlungsempfindlichen biologischen Materials, das in einem lyotropen Flüssigkristall eingebettet ist,
**dadurch gekennzeichnet**
daß die Anordnung mindestens aus einem Tensid, aus Bakteriorhodopsin oder Bakteriorhodopsin enthaltenden Membranstücken und Wasser besteht.

2. Bioelektrische Anordnung nach Anspruch 1, **dadurch gekennzeichnet,** daß als Tensid Polyoxyethylenmonolaurylether, n-Polyoxyethylen-m-alkylether, N-Laurylsarkosin (NLS) oder Cetylpyridiniumchlorid (CPC) verwendet wird.

3. Bioelektrische Anordnung nach Anspruch 2, **dadurch gekennzeichnet,** daß bei Verwendung von NLS und CPC ein mit Wasser nicht mischbares Lösungsmittel zugefügt ist.

4. Bioelektrische Anordnung nach Anspruch 3, **dadurch gekennzeichnet,** daß als Lösungsmittel Hexan oder Benzol zugefügt ist.

5. Bioelektrische Anordnung nach mindestens einem der vorhergehenden Ansprüche, **dadurch gekennzeichnet,** daß der lyotrope Flüssigkristall als Schicht zwischen zwei Glasplatten eingebracht ist und die Elektroden in diese Schicht eingefügt sind.

6. Bioelektrische Anordnung nach Anspruch 5, **dadurch gekennzeichnet,** daß die Schicht eine Dicke von 0,2 bis 0,5 mm aufweist.

7. Bioelektrische Anordnung nach mindestens einem der Ansprüche 1 bis 4, **dadurch gekennzeichnet,** daß der Flüssigkristall in einem lichtdurchlässigen Rohr, das an den Stirnseiten verschlossen ist, vorgesehen ist.

8. Bioelektrische Anordnung nach Anspruch 7, **dadurch gekennzeichnet,** daß an den Stirnseiten des Rohres Schieber vorgesehen sind.

9. Bioelektrische Anordnung nach einem der Ansprüche 7 und 8, **dadurch gekennzeichnet,** daß sich die Elektroden durch die Stirnseiten des Rohres in den Flüssigkristall erstrekken.

10. Bioelektrische Anordnung nach mindestens einem der vorhergehenden Ansprüche, **dadurch gekennzeichnet,** daß als Elektroden Edelmetallelektroden vorgesehen sind.

11. Bioelektrische Anordnung nach mindestens einem der Ansprüche 1 bis 4**, dadurch gekennzeichnet,** daß der lyotrope Flüssigkristall zwischen zwei elektrisch leitenden Gläsern oder zwei mit Edelmetallen bedampften Gläsern eingebracht ist.

12. Bioelektrische Anordnung nach Anspruch 11, **dadurch gekennzeichnet,** daß die Gläser gleichzeitig Elektroden sind.

13. Bioelektrische Anordnung nach mindestens einem der Ansprüche 1 bis 12, **dadurch gekennzeichnet,** daß sie zur Detektion von sichtbarem Licht, UV-Licht und Gammastrahlen verwendet wird.
